# EUROPÄISCHE PATENTSCHRIFT

(11) **EP 0 870 850 B1**
(45) Veröffentlichungstag und Bekanntmachung des Hinweises auf die Patenterteilung: **18.09.2002**
(21) Anmeldenummer: 98103207.1
(22) Anmeldetag: 24.02.1998
(51) Int. Cl.: C23C 14/56

(54) **Verfahren und Vorrichtung zum Be- und Entladen einer evakuierbaren Behandlungskammer**
Method and apparatus for loading and unloading an evacuable treatment chamber
Procédé et appareil de chargement et déchargement d'une enceinte de traitement

(30) Priorität: 11.04.1997 DE 19715151; 11.04.1997 DE 29706556 U
(43) Veröffentlichungstag der Anmeldung: 14.10.1998
(73) Patentinhaber: Leybold Systems GmbH, 63450 Hanau (DE)
(72) Erfinder: Henrich, Jürgen, 63694 Limeshain (DE); Ickes, Gerd, 63512 Hainburg (DE)
(74) Vertreter: Bockhorni, Josef, Dipl.-Ing.

(56) Entgegenhaltungen:
- EP-A- 0 449 227
- DE-A- 4 332 674
- US-A- 4 699 554

## Beschreibung

Die Erfindung bezieht sich auf eine Be- und Entladevorrichtung für eine evakuierbare Kammer nach dem Oberbegriff des Patentanspruchs 1 und auf ein Verfahren zum Be- und Entladen einer derartigen Behandlungskammer gemäß Patentanspruch 4 bzw. 5.

Derartige Be- und Entladevorrichtungen dienen dazu, zu bearbeitende Werkstücke, z.B. zu beschichtende Formteile einer Vakuumbeschichtungsanlage zuzuführen bzw. die beschichteten Formteile der Beschichtungsanlage zu entnehmen. Hierzu weisen derartige Beschichtungsanlagen eine Ein-/Ausschleusstation auf, in bzw. aus welcher die Werkstücke transportierbar sind. Der Ein- bzw. Ausschleusvorgang selbst erfordert, daß die Schleusenstation zu belüften bzw. zur Bearbeitung der Werkstücke in der Vakuumkammer zu evakuieren ist.

Bei den bekannten gattungsgemäßen Be-/Entladevorrichtungen (Handlingsvorrichtungen) ist vorgesehen, daß zum Entladen der bereits belufteten Schleusenstation zunächst die Schleusentür durch seitliches Auffahren geöffnet wird, danach fährt ein Handlingsarm in die Schleusenstation und greift einen die Formteile aufnehmenden Substrattrager. Dieser erste Handlingsarm fährt nun aus der Schleusenstation soweit heraus, daß ein zweiter Handlingsarm mit einem unbeschichtete Formteile tragenden Substratträger in die Schleusenstation verfahrbar ist. Der zweite Handlingsarm übergibt danach den Substratträger auf eine Haltevorrichtung in der Schleusenstation. Nach dieser Übergabe wird der zweite Handlingsarm aus der Schleusenstation herausgefahren und diese mit der seitlich verfahrenden Schleusentur geschlossen. Anschließend werden die in die Vakuumkammer eingebrachten Werkstucke innerhalb der Vakuumkammer an eine Bearbeitungsstation übergeben.

Ein Nachteil dieser bekannten Be-/Entladevorrichtung ist, daß die Zeitdauer zum Beschicken bzw. zum Entladen der Schleusenstation im Verhältnis zur gesamten für den Beschichtungsprozeß erforderlichen Bearbeitungszeit groß ist. Insbesondere bei sogenannten Kurztakt-Beschichtungsanlagen ist es wünschenswert, die Zykluszeit, d. h. die insgesamt zwischen zwei Beschickungsvorgängen verstreichende Zeit, möglichst gering zu halten.

Der Erfindung liegt die Aufgabe zugrunde, eine Be-/Entladevorrichtung bereitzustellen, mittels welcher die Zykluszeit des in einer Vakuumanlage durchzuführenden Beschichtungsprozesses unter Verwendung einfacher Mittel minimal gehalten werden kann.

Diese Aufgabe wird erfindungsgemäß durch die im kennzeichnenden Teil des Patenanspruchs 1 angegebenen Mittel gelöst. Weiterhin wird ein erfindungsgemäßes Verfahren gemäß Anspruch 4 bzw. 5 zum Be- bzw. Entladen einer Vakuumkammer angegeben, mit welchem unter Einsatz der erfindungsgemäßen Mittel die Be- und/oder Entladezeit einer Vakuumkammer mit dieser zu bearbeitenden Werkstücken minimiert wird.

Nach Anspruch 1 besteht eine erfindungsgemäße Be-/Entladevorrichtung im wesentlichen aus mindestens einem um eine raumfeste Achse drehbar gelagerten Schubteil, welches in einer beliebig vorgewählten Rotationsposition radial in Bezug zur Drehachse zwischen einer Offen-Position und einer Geschlossen-Position verschiebbar ist. An dem Schubteil ist der die Be-/Entladeöffnung der Ein-/Ausschleusstation verschließende Deckel angeordnet. Zur Aufnahme und zum Transport der in die Ein-/Ausschleusstation zu transportierenden Werkstücke weist der Deckel eine die zu bearbeitenden, vorzugsweise zu beschichtenden Werkstücke aufnehmende Haltevorrichtung auf. Durch die Ausbildung des Schubteils sowohl als Deckelteil und als die Werkstücke transportierende Haltevorrichtung, besitzt das Schubteil eine Doppelfunktion, die die für die Be- bzw. Entladung der Vakuumkammer erforderliche Zeitdauer vorteilhaft verkürzt und die damit den automatischen Be-/Entladevorgang bei einer Kurztakt-Beschichtungsanlage vorteilhaft erst ermöglicht.

Ein weiterer Vorteil ergibt sich erfindungsgemäß mit den in Anspruch 2 angegebenen Merkmalen. Danach sind mindestens zwei Schubteile vorgesehen, welche vorzugsweise diametral in Bezug zur Drehachse einander gegenüberliegend angeordnet sind. Dies hat den Vorteil, daß die Beladung der Schleusenstation durch das erste Schubteil parallel zur Beladung der Haltevorrichtung des zweiten Schubteils mit in der Vakuumkammer zu behandelnden Werkstücken erfolgen kann. Zum Entladen bzw. neuen Beladen der Schleusenstation wird dann das zweite Schubteil, vorzugsweise fest gekoppelt zum ersten Schubteil synchron mit diesem um die Achse vor die geöffnete Schleusenstation gedreht und die unbeschichteten Werkstücke in die Schleusenstation eingebracht, wobei die Vakuumkammer gleichzeitig evakuierbar verschlossen wird. Durch die Verwendung mehrerer, vorzugsweise synchron betatigter Schubteile erfolgen mehrere Bewegungsabläufe zeitlich parallel zueinander, wodurch eine weitere Senkung der Zykluszeit des Beschichtungsprozesses erreicht wird. Ein weiterer Vorteil hierbei ist, daß die manuelle Beladung der Beschichtungsanlage ohne Zykluszeitvergroßerung möglich ist, da die Werkstuckträger nicht mehr in der Schleusenstation, sondern außerhalb an der Be-/Entladevorrichtung gewechselt werden.

Ein weiterer Vorteil ergibt dadurch, daß der am Schubteil ausgebildete Deckel einen Verdrängungskorper (siehe Anspruch 3) aufweist, welcher gemeinsam mit den zu beschichtenden Werkstücken in die Ein-/Ausschleusstation einbringbar ist, wodurch das insgesamt zu evakuierende Volumen der Vakuumkammer verringert wird. Hierdurch verringert sich vorteilhaft die zum Erreichen des Arbeitsvakuums erforderliche Abpumpzeit, wodurch eine weitere Verringerung der Zykluszeit bewirkt wird.

Die Erfindung wird im folgenden anhand eines in Zeichnungen dargestellten, besonders bevorzugten Ausführungsbeispiels näher erläutert. Es zeigen:
- Fig. 1: eine erfindungsgemäße Be-/Entladevorrichtung in Seitenansicht sowie eine mit Werkstucken zu beschickende, zugeordnete Vakuumkammer;
- Fig. 2: einen horizontalen Querschnitt durch eine Be-/Entladevorrichtung mit einem 2-armigen Hebelgetriebe in der Geschlossen-Position;
- Fig. 3: eine Querschnittsansicht gemäß Fig. 2 in der Offen-Position der Be-/Entladevorrichtung;
- Fig. 4: eine Querschnittsansicht einer Be-/Entladevorrichtung mit zwei um eine vertikale Achse verschwenkbaren Schubteilen und
- Fig. 5: eine Querschnittsansicht der in Fig. 4 dargestellten Be-/Entladevorrichtung nach Verschwenken der Schubteile um 180° um eine vertikal Achse.

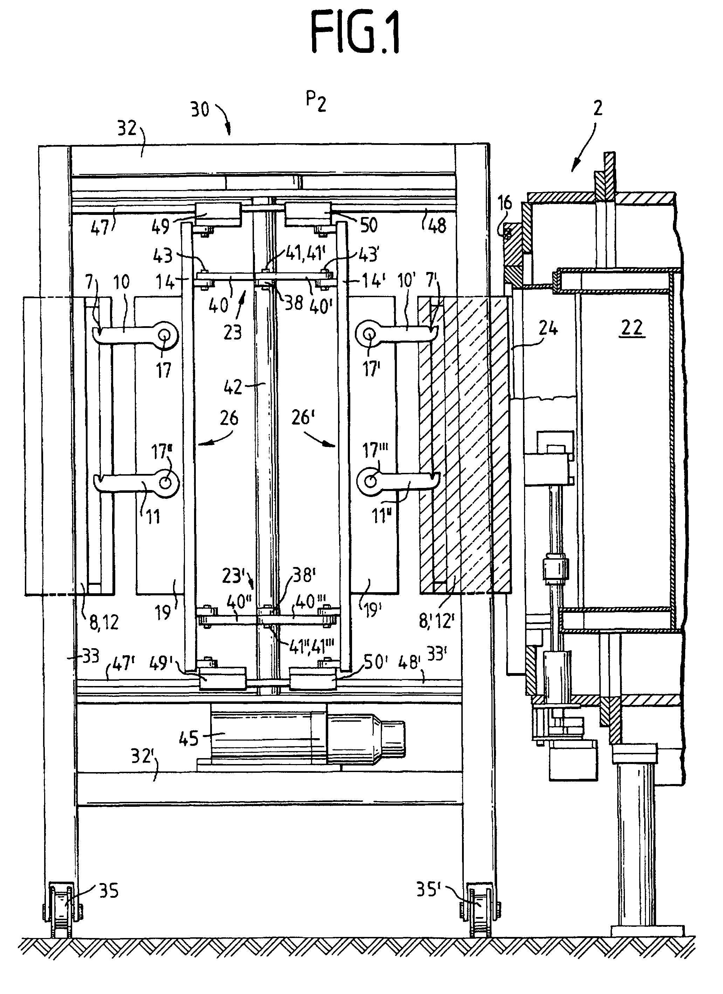

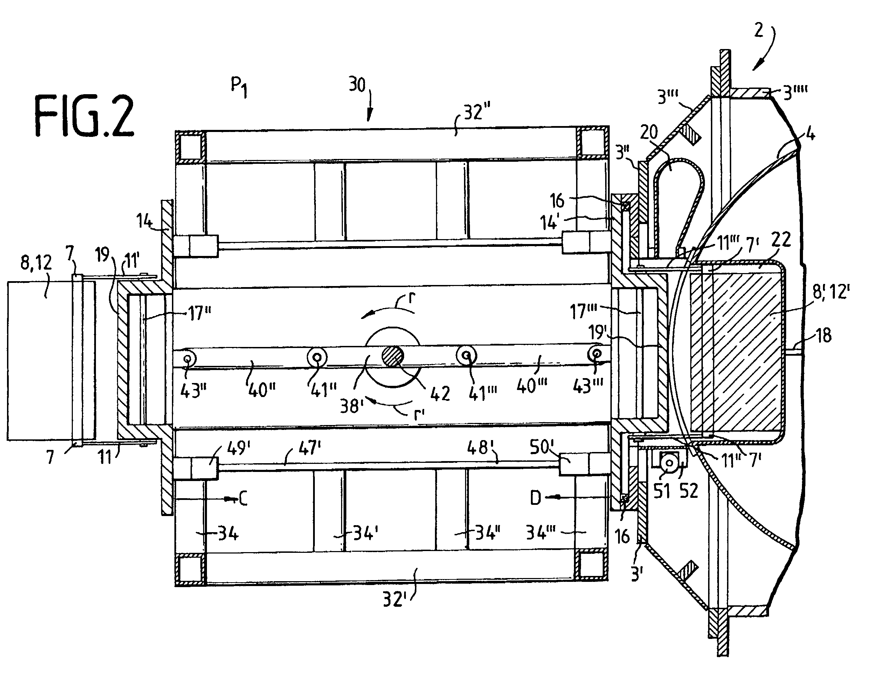

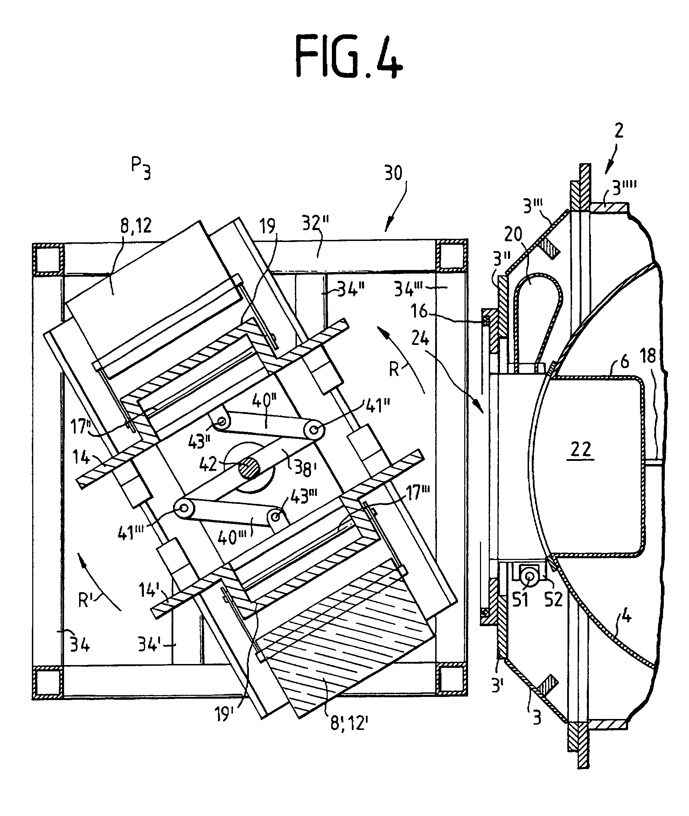

In der Fig. 1 ist eine einer mit Werkstücken zu beschickenden Vakuumkammer 2 zugeordneten Be/Entladevorrichtung 30 dargestellt. Die Vakuumkammer 2 weist mehrere Kammern, nämlich z. B. eine Behandlungsstation, eine Schleusenstation sowie sogenannte Substratkammern auf, von denen jedoch in den Fig. 2 bis 5 lediglich die Ein/Ausschleusstation 22 dargestellt ist. Zum Beschicken der Schleusenstation 22 mit in der Vakuumkammer 2 zu bearbeitenden Werkstücken 8,8' ist die Be-/Entladevorrichtung 30 gegenüber der in der Vakuumkammerwand 3,3',3'',3''' eingelassenen Öffnung 24 angeordnet. Die Be-/Entladevorrichtung 30 umfaßt ein Gestell 32,32',32'', welches von rechteckig zueinander angeordneten Gestellbeinen 33,33', welche auf Rollen 35,35' lagern, in seiner flächenmaßigen Ausdehnung begrenzt wird. Mit den Rollen 35,35' ist die Be-/Entladevorrichtung vor der Vakuumkammer 2 verfahrbar, um z. B. den Zugang für Wartungsarbeiten an der Vakuumkammer 2 zu ermöglichen. Wahrend der Be- und Entladevorgänge ist das Gestell 32,32',32'' mit der in diesem integrierten Be-/Entladevorrichtung 30 ortsfest vor der Vakuumkammer 2 positioniert.

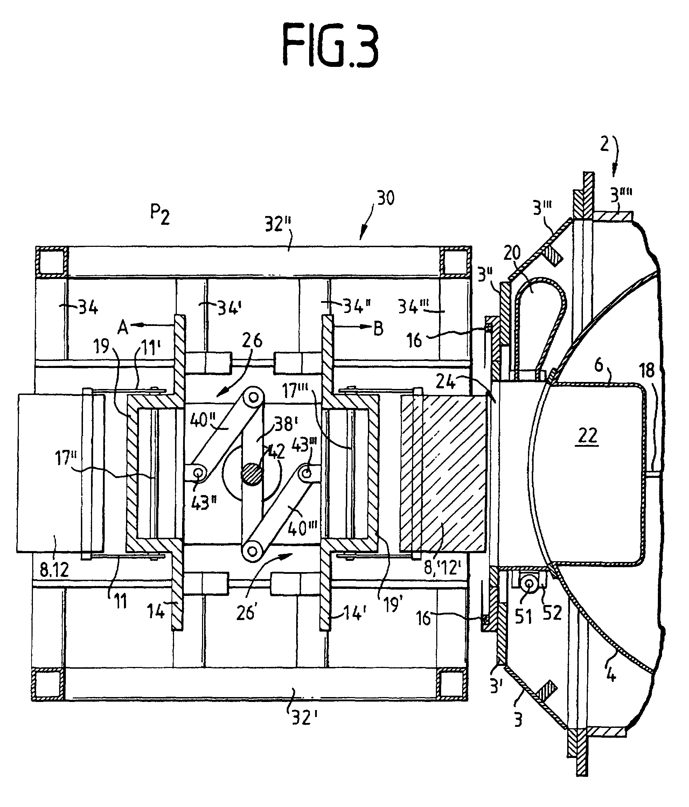

Die Be-/Entladevorrichtung 30 umfaßt zwei um 180° rotationssymmetrisch zu einer Vertikalachse 42 angeordnete Schubteile 26,26', welche mit in einer oberen Führungsschiene 47,48 eingreifenden Schlittenkörpern 49,50 sowie in untere Führungsschienen 47',48' eingreifenden Schlittenkörpern 49',50' in dem Gestell 32,32',32''; 34,34',34'' verschiebbar gelagert sind. Mit der von einem Motor 45 betätigten Antriebsachse 42 ist ein Arm 38 als Teil eines Hebelgetriebes 23 fest verbunden, welcher an seinen beiden Enden über je ein Gelenk 41,41' mit einer Schub-/Zugstange 40,40' verschwenkbar verbunden ist, wobei die Schub-/Zugstange 40,40' jeweils mit einem Gelenkkörper 43,43' an den einander in Bezug zur Achse 42 spiegelsymmetrisch zueinander angeordneten Schubteilen 14,14' angelenkt sind. Die Schubteile 14,14' sind als Deckel zum Verschließen der Öffnung 24 ausgebildet. Hierzu weisen die Deckel 14,14' auf den der Vakuumkammer 2 in der Geschlossen-Position P₁ zugewandten Seite jeweils Dichtflächen auf, welche in Zusammenwirken mit der Öffnung 24 seitlich zugeordneten Dichtungselementen 16 die Vakuumkammer 2 evakuierbar abdichten. An den Deckeln 14,14' sind Greifarme 10',11' bzw. 10'',11'' paarig (siehe Fig. 3) angeordnet. Die paarig vorhandenen Greifarme 10',11' bzw. 10'',11'' sind jeweils über in einem Vorsprung 19,19' des Deckels 14 gelagerte Stangen 17,17' endseitig an diesem befestigt, wodurch die Greifarme 10' und 11' bzw. 10'' und 11'' jeweils über die Stange 17 bzw. 17', 17", 17"' schwenkbar miteinander gekoppelt sind.

Zum Entladen von in der Vakuumkammer 2 z. B. zu beschichtenden Werkstücken 8 wird die Ein-/Ausschleusstation 22 in ihre Entnahmeposition, wie in Fig. 2 bis 5 dargestellt, durch Drehung des Innenzylinders 4 durch Rotation des angetriebenen Arms 18 von einer in den Zeichnungen nicht dargestellten Welle gefahren. Durch betätigen der Stangen 17, 17, 17", 17"' werden die Greifarme 10,11 heraufgeschwenkt und greifen den Substratträger 12 an seitlich an diesen dafür vorgesehenen Halteelementen 7,7' auf. Während dieser Übergabe des Substratträgers 12 an die Greifarme 10,11 wird die . Ein-/Ausschleusstation 22 zeitgleich auf Atmosphärendruck durch Einlassen eines Gases über einen in der Zeichnung nicht dargestellten Gaseinlaß belüftet. Nachdem der Druckausgleich in der Ein-/Ausschleusstation 22 hergestellt ist, wird durch Drehung der von der Antriebsvorrichtung 45 (siehe Fig. 1) angetriebenen Welle 42 in die Drehrichtung r' die Schub/Zugstange 40,40' in dem Gelenk 41,41' verschwenkt, wobei das Schubteil 26 und 26' bewegungssynchron über das Gelenk 43 bzw. 43' auf die Antriebswelle 42 zu verschoben werden. Hierdurch wird der Deckel 14 von der äußeren Vakuumkammerwand 3',3'' abgehoben und zusammen mit den auf dem Substratträger 12 lagernden, beschichteten Werkstücken 8' aus der Ein-/Ausschleusstation 22 entnommen.

Zur Entnahme der beschichteten Werkstücke 8 von dem Subtratträger 12 werden die Schubteile 26,26' gemeinsam mit dem zweiarmigen Hebelgetriebe 23 um die Antriebswelle 42 in Drehrichtung R' um 180° verschwenkt. Das Schleusenhandling 30 wird anschließend durch Betätigen des Hebelgetriebes 23, wobei die Antriebswelle 42 um 180° in Drehrichtung r (siehe Fig. 2) gedreht wird, aus der Offen-Position P₂ in die in Fig. 2 dargestellte Geschlossen-Position P₁ überführt. Alternativ ist auch eine um 180°-fortgesetzte Drehung in Drehrichtung r' möglich. Hierbei wird der von den Greifarmen 10',11' gehaltene Substrattrager 12' mit den auf diesem lagernden, zu beschichtenden Substraten 8' vor die Öffnung 24 positioniert in die Ein/Ausschleusstation 22 durch Betätigen des Hebelgetriebes 23 überführt und die Öffnung 24 mit der Schleusenklappe 14' sowie von den in der Vakuumkammerwand 3',3'' eingelassenen Dichtungsvorrichtungen 16 vakuumdicht verschlossen.

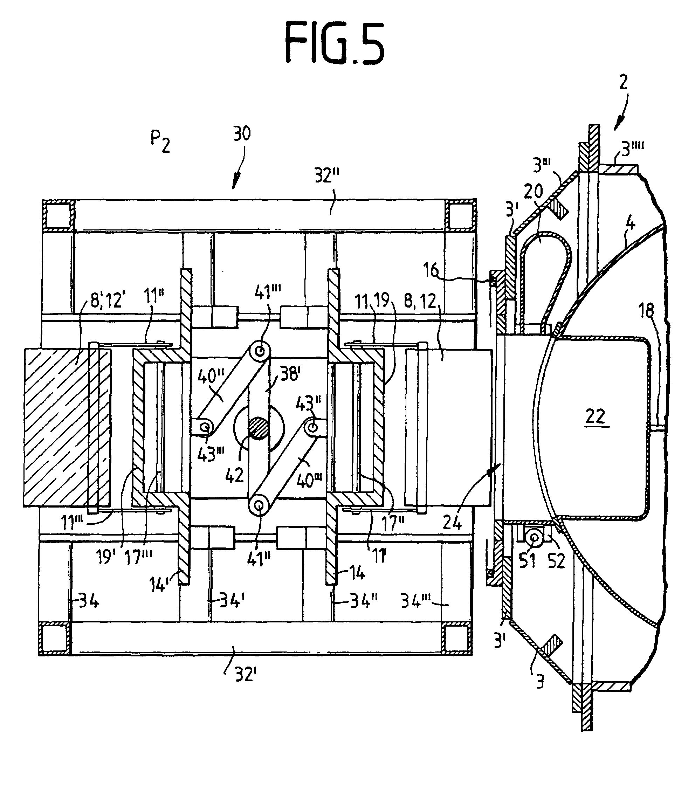

Anschließend wird der Substratträger 12' durch Verschwenken der Greifarme 10',11' zum Weitertransport durch Drehung des Innenzylinders 4 (siehe Fig. 5) an die Einschleus-/Ausschleusstation 22 übergeben. Parallel zu dem Übergabevorgang wird die Vakuumkammer 2 mittels einer in den Zeichnungen nicht dargestellten Pumpvorrichtung über den Saugstutzen 20 (siehe Fig. 2 bis 5) auf ihren Arbeitsenddruck evakuiert.

Die zuvor beschichteten, außerhalb der Vakuumkammer befindlichen Substrate 8 können nunmehr gemeinsam mit ihrem Substratträger 12 oder substratweise von dem Substratträger 12 z. B. durch ein Roboterhandling entnommen werden. Das in der Geschlossen-Position P₁ befindliche Schubteil 26' steht danach zum Wiederbeladen mit von zu beschichtenden Substraten zur Verfügung.

### Bezugszeichenliste

- 2: Vakuumkammer, Behandiungskammer
- 3,3',3",3"': Vakuumkammerwand, Außenwand
- 4: Innenzylinder
- 6: Substratkammer
- 7,7': Halteelement
- 8,8': Substrat, Werkstück
- 10,10',10": Greifarm
- 11,11',11": Greifarm
- 12,12': Substratträger, Werkstückträger
- 14,14': Schleusenklappe, Deckel
- 16: Dichtungsvorrichtung, Dichtungselement
- 17,17',17",17"': Stange
- 18: Arm
- 19,19': Vorsprung
- 20: Saugstutzen
- 21: Verdrängungskörper
- 22: Ein-/Ausschleusstation
- 23: Hebelgetriebe
- 24: Öffnung
- 26,26': Schubteil
- 30: Schleusenhandling, Be-/Entladevorrichtung
- 32,32',32": Gestell
- 33,33': Gestellbein
- 34,34',34": Gestell
- 35,35': Rolle
- 36: Plattform
- 38: Arm
- 40,40': Schub-/Zugstange
- 41,41': Gelenk
- 42: Antriebsachse, Welle, Drehachse
- 43,43': Gelenk
- 44: Saugstutzen
- 45: Antriebsvorrichtung, Motor
- 47,47': Führungsschiene
- 48,48': Führungsschiene
- 49,49': Schlittenkörper
- 50,50': Schlittenkorper
- 51: Welle
- 52: Kulisse

- A,B,C,D: Schubrichtung
- R,R': Drehrichtung des Schubteils 26,26'
- r,r': Drehrichtung der Welle 42

- P₁: Geschlossen-Position
- P₂: Offen-Position
- P₃: Wechsel-Position

## Patentansprüche

1. Vorrichtung zum Be- und Entladen von einer in einer Vakuumkammer (2) angeordneten Bearbeitungsstation mit zu bearbeitenden Werkstücken (8,8'), wobei die Werkstücke (8,8') durch mindestens eine in einer Kammerwand (3,3',3") der Vakuumkammer (2) eingelassene, mit einem Deckel (14,14') verschließbare Öffnung (24) in die Vakuumkammer (2) ein- und ausbringbar sind, **dadurch gekennzeichnet, daß** die Vorrichtung mindestens ein um eine in Bezug zur Öffnung (24) raumfeste Drehachse (42) drehbares Schubteil (26,26') aufweist, welches vorzugsweise mittels eines Hebelgetriebes 23, das insbesondere einen einerends an den Dekkel (14,14') und andernends an einen mit der Drehachse (42) fest verbundenen Arm (38) angelenkte Schub-/Zugstange (40,40') aufweist, radial in Bezug zur Achse (42) verschiebbar ist und wobei an dem Schubteil (26,26'), vorzugsweise an dem Deckel (14,14') zur Aufnahme und zum Transport der Werkstücke (8,8') mindestens eine Greifvorrichtung (10,10';11,11') angeordnet ist, und wobei durch Drehung der Achse (42) die Schub-/Zugstange (40,40') mit ihrem am Deckel (14,14') angelenkten Ende in radialer Richtung in Bezug zur Achse (42) zwischen einer achsennahen Offen-Position (P₂) und einer achsenfernen Schließposition (P₁) des Deckels (14,14') in Bezug zur Öffnung (24) verschiebbar ist, wobei die Greifvorrichtung (10,10';11,11') derartig am Deckel (14,14') angeordnet ist, daß diese in der Schließposition (P₁) des Deckels (14,14') vollständig in die Vakuumkammer (2) hineinragt.

2. Vorrichtung nach Anspruch 1, **dadurch gekennzeichnet, daß** mindestens zwei, vorzugsweise in Bezug zur Achse (42) diametral gegenüberliegende Schubteile (26,26') vorgesehen sind, die jeweils einen Deckel (14,14') aufweisen, und welche in Bezug zur Achse (42), vorzugsweise in einer gekoppelten, entgegengerichteten Bewegung radial verschiebbar sind, wobei die Schubteile (26,26') in mindestens einer Drehrichtung (R,R') um die Achse (42) rotierbar sind.

3. Vorrichtung, insbsondere nach Anspruch 1 und/oder Anspruch 2, **dadurch gekennzeichnet, daß** der Deckel (14, 14') einen Verdrängungskörper (19) aufweist, welcher beim Schließen der Öffnung 24 durch den Deckel (14, 14') in die Ein/Ausschleusstation (22) derartig hineinragt, daß deren evakuierbares Volumen verringert wird.

4. Verfahren zum Beladen von einer in einer Vakuumkammer (2) angeordneten Bearbeitungsstation, vorzugsweise zum Beschichten von Werkstücken (8,8'), insbesondere von Substraten (8,8'), wobei die Werkstücke (8,8') durch mindestens eine in einer Kammerwand (3,3',3'') der Vakuumkammer (2) vorgesehene, mit einem Deckel (14,14') verschließbaren Öffnung (24) in die Vakuumkammer (2) eingebracht werden, und wobei folgende Verfahrensschritte vorgesehen sind:
a. Beladen der an einem Schubteil (26,26') der Be-/Entladevorrichtung (30) angeordneten Substratträger (12) mit zu bearbeitenden Werkstücken (8);
b. Drehung des beladenen Schubteils (26,26') um eine in Bezug zur Vakuumkammer (2) raumfeste Achse (42) vor die Öffnung (24);
c. Einbringen des Werkstückträgers (12) in die Vakuumkammer (2) durch Vortrieb des Schubteils (26,26') entlang einer in Bezug zur Achse (42) radialen Bewegungsrichtung, wodurch die Öffnung (24) mit einem mit dem Schubteil (26,26') verbundenen Deckel (14,14') verschlossen wird.

5. Verfahren zum Entladen einer mit bearbeiteten Werkstücken (8') gefüllten Vakuumkammer (2), wobei die Werkstucke (8') durch mindestens eine in einer Kammerwand (3,3',3'') der Vakuumkammer (2) eingelassenen, mit einem Deckel (14,14') verschließbaren Öffnung (24) aus der Vakuumkammer (2) ausgebracht werden, wobei folgende Verfahrensschritte vorgesehen sind:
a) Beluften der Vakuumkammer (2) durch Einlassen eines Gases;
b) Ausbringen des mit den Werkstücken (8') beladenen Werkstücktragers (12') durch radiales Verschieben des Schubteils (26) entlang einer in Bezug zur Achse (42) von der Vakuumkammer (2) wegweisenden Bewegungsrichtung;
c) Drehung des Schubteils (26,26') um die Achse (4) in eine Entnahmeposition zum maschinellen und/oder manuellen Entladen der bearbeiteten Werkstucke (8').

6. Verfahren nach Anspruch 4, wobei die Evakuierung der Vakuumkammer (2) begonnen wird, während der Werkstückträger (12,12') an einen in der Vakuumkammer (2) vorgesehenen Greifarm übergeben wird.

7. Verfahren nach Anspruch 5, wobei die Vakuumkammer (2) belüftet wird, während der aus der Vakuumkammer (2) zu entnehmende Werkstückträger (12,12') von dem an dem Schubteil (26,26') angeordneten Greifarm (10,10',10''; 11,11',11'') übernommen wird.

## Claims

1. Apparatus for loading and unloading a processing station, which is disposed in a vacuum chamber (2), with workpieces (8, 8') to be processed, whereby the workpieces (8, 8') may be introduced into and removed from the vacuum chamber (2) through at least one opening (24), which is set into a chamber wall (3, 3', 3") of the vacuum chamber (2) and is closable with a cover (14, 14'), **characterised in that** the apparatus has at least one push member (26, 26'), which is rotatable about a rotary shaft (42), spatially fixed with respect to the opening (24) and which is movable radially with respect to the shaft (42) by means of a lever drive mechanism (23), which has, in particular, a push/pull rod (40, 40') pivotally connected at one end to the cover (14, 14') and at the other end to an arm (38) rigidly connected to the rotary shaft (42) and whereby arranged on the push member (26, 26'), preferably on the cover (14, 14'), there is at least one gripping device for receiving and for transporting the workpieces (8, 8') and whereby, by rotation of the shaft (42), the end of the push/pull rod (40, 40') pivotally connected to the cover (14, 14') is movable in the radial direction with respect to the shaft (42) between an opening position (P₂) close to the shaft and a closed position (P₁), remote from the shaft, of the cover (14, 14') with respect to the opening (24), whereby the gripping device (10, 10'; 11, 11') is so arranged on the cover (14, 14') that it projects in the closed position (P₁) of the cover (14, 14') completely into the vacuum chamber (2).

2. Apparatus as claimed in Claim 1, **characterised in that** at least two push members (26, 26') are provided, which are preferably diametrically opposed to one another with respect to the shaft (42) and which each have a cover (14, 14') and which are radially movable with respect to the shaft (42), preferably in a coupled oppositely directed movement, whereby the push members (26, 26') are rotatable about the shaft (42) in at least one direction of rotation (R, R').

3. Apparatus, particularly as claimed in Claim 1 and/or Claim 2, **characterised in that** the cover (14, 14') has a displacement body (19) which, when the opening (24) is closed by the cover (14, 14') extends into the charging/discharging station (22) such that its evacuable volume is reduced.

4. Method of loading a processing station, particularly for coating workpieces (8, 8') particularly substrates (8, 8'), disposed in a vacuum chamber (2), wherein the workpieces (8, 8') are introduced into the vacuum chamber (2) through at least one opening (24), which is provided in a chamber wall (3, 3', 3") of the vacuum chamber (2) and is closable with a cover (14, 14') and wherein the following method steps are provided:
a. loading the substrate carrier (12) disposed on a push member (26, 26') of the loading/unloading apparatus (30) with workpieces (8) to be processed;
b. rotating the loaded push member (26, 26') about a shaft (42), which is spatially fixed with respect to the vacuum chamber (2), in front of the opening (24);
c. introducing the workpiece carrier (12) into the vacuum chamber (2) by advancing the push member (26, 26') in a direction of movement, which is radial with respect to the shaft (42), whereby the opening (24) is closed with a cover (14, 14') connected to the push member (26, 26').

5. Method of unloading a vacuum chamber (2) filled with processed workpieces (8'), wherein the workpieces (8') are removed from the vacuum chamber (2) through at least one opening (24), which is set in a chamber wall (3, 3', 3") of the vacuum chamber (2) and is closable with a cover (14, 14'), wherein the following method steps are provided:
a) ventilating the vaccum chamber (2) by permitting the entry of a gas;
b) removing the workpiece carrier (12') loaded with the workpieces (8') by radial movement of the push member (26) in a direction of movement directed away from the vacuum chamber (2) with respect to the shaft (42);
c) rotating the push member (26, 26') about the shaft (42) into a removal position for mechanical and/or manual unloading of the processed workpieces (8').

6. Method as claimed in Claim 4, wherein the evacuation of the vacuum chamber (2) is commenced whilst the workpiece carrier (12, 12') is transferred on a gripper arm provided in the vacuum chamber (2).

7. Method as claimed in Claim 5, wherein the vacuum chamber (2) is ventilated whilst the workpiece carrier (12, 12'), which is to be removed from the vacuum chamber (2), is taken over by the gripper arm (10, 10', 10"; 11, 11', 11") disposed on the push member (26, 26').

## Revendications

1. Appareil pour le chargement et le déchargement d'une enceinte de traitement disposée dans une chambre à vide (2) avec des pièces à usiner à traiter (8, 8'), les pièces à usiner (8, 8') étant chargeables et enlevables dans la chambre à vide (2) par le biais d'au moins une ouverture (24) enchâssée dans une paroi de chambre (3, 3', 3") de la chambre à vide (2), verrouillable par un couvercle (14, 14'), **caractérisé en ce que** l'appareil présente au moins une pièce de poussée (26, 26') pivotant autour d'un axe de rotation (42) stabilisé par rapport à l'ouverture (24), laquelle de préférence au moyen d'une transmission à levier (23), qui présente en particulier une tige de poussée/traction (40, 40') articulée à une extrémité au couvercle (14, 14') et à l'autre extrémité à un bras (38) relié de manière fixe à l'axe de rotation (42), laquelle transmission est mobile radialement par rapport à l'axe (42) et moyennant quoi au moins un dispositif de préhension à griffes (10, 10' ; 11, 11') est disposé sur la pièce de poussée (26, 26'), de préférence sur le couvercle (14, 14') pour le logement et le transport des pièces à usiner (8, 8'), et la tige de poussée / de traction (40, 40') étant, par le biais de la rotation de l'axe (42), mobile par rapport à l'ouverture (24) avec son extrémité articulée sur le couvercle (14, 14') dans le sens radial par rapport à l'axe (42) entre une position d'ouverture (P₂) proche de l'axe et une position de fermeture (P₁) éloignée de l'axe du couvercle (14, 14'), le dispositif de préhension à griffes (10, 10' ; 11, 11') étant disposé sur le couvercle (14, 14') de telle façon que celui-ci pénètre intégralement dans la chambre à vide (2) en position de fermeture (P₁) du couvercle (14, 14').

2. Appareil selon la revendication 1, **caractérisé en ce que** sont prévues au moins deux pièces de poussée (26, 26') de préférence diamétralement opposées par rapport à l'axe (42), qui présentent respectivement un couvercle (14, 14') et qui sont mobiles radialement par rapport à l'axe (42), de préférence dans un mouvement couplé, en sens inverse, les pièces de poussée (26, 26') étant mobiles autour de l'axe (42) dans au moins un sens de rotation (R, R').

3. Appareil, en particulier selon la revendication 1 et/ou la revendication 2, **caractérisé en ce que** le couvercle (14, 14') présente un corps déplaceur (19), lequel pénètre dans l'enceinte d'éclusage intérieur/extérieur (22) lors de la fermeture de l'ouverture (24) par le biais du couvercle (14, 14') de telle façon que son volume évacuable soit réduit.

4. Procédé de chargement d'une enceinte de traitement disposée dans une chambre à vide (2), destinée de préférence au revêtement de pièces à usiner (8, 8'), en particulier de substrats (8, 8'), les pièces à usiner (8, 8') étant chargées dans la chambre à vide (2) par le biais d'au moins une ouverture (24) prévue dans une paroi de chambre (3, 3', 3") de la chambre à vide (2), verrouillable avec un couvercle (14, 14') et les étapes de procédé suivantes étant prévues :
a. chargement des supports de substrats (12) disposés sur une pièce de poussée (26, 26') du dispositif de chargement / déchargement (30) avec des pièces à usiner (8) à traiter ;
b. rotation de la pièce de poussée (26, 26') chargée autour d'un axe (42) stabilisé par rapport à la chambre de vide (2) devant l'ouverture (24) ;
c. chargement du support de pièce à usiner (12) dans la chambre de vide (2) par le biais de l'avancement de la pièce de poussée (26, 26') le long d'un sens de mouvement radial par rapport à l'axe (42), moyen par lequel l'ouverture (24) est verrouillée grâce à un couvercle (14, 14') relié à la pièce de poussée (26, 26').

5. Procédé destiné au déchargement d'une chambre à vide (2) remplie de pièces à usiner (8') traitées, les pièces à usiner (8') étant enlevées de la chambre à vide (2) par le biais d'au moins une ouverture (24) enchâssée dans une paroi de chambre (3, 3', 3") de la chambre à vide (2), verrouillable grâce à un couvercle (14, 14'), les étapes de procédé suivantes étant prévues :
a) ventilation de la chambre à vide (2) par le biais de l'admission d'un gaz ;
b) enlèvement du support de pièces à usiner (12') chargé avec les pièces à usiner (8') par le biais d'un déplacement radial de la pièce de poussée (26) le long d'un sens de mouvement avec indication de la direction à partir de la chambre à vide (2) par rapport à l'axe (42) ;
c) rotation de la pièce de poussée (26, 26') autour de l'axe (4) dans une position de prélèvement pour le déchargement mécanique et/ou manuel des pièces à usiner traitées (8').

6. Procédé selon la revendication 4, l'évacuation de la chambre à vide (2) étant lancée, tandis que le support de pièces à usiner (12, 12') est remis à un bras de prise prévu dans la chambre de vide (2).

7. Procédé selon la revendication 5, la chambre à vide (2) étant ventilée, tandis que le support de pièces à usiner (12, 12') à enlever de la chambre à vide (2) est pris en charge par le bras de prise (10, 10', 10" ; 11, 11', 11") disposé sur la pièce de poussée (26, 26').
